# EUROPÄISCHE PATENTANMELDUNG

(11) **EP 2 037 549 A2**
(43) Veröffentlichungstag der Anmeldung: **18.03.2009**
(21) Anmeldenummer: 08013780.5
(22) Anmeldetag: 31.07.2008
(51) Int. Cl.: H01S 5/026, H01S 5/04, H01S 5/183, H01S 5/10, H01S 5/40

(54) **Halbleitervorrichtung mit Winkelreflektor**

(30) Priorität: 11.09.2007 DE 102007043189; 08.11.2007 DE 102007053296
(71) Anmelder: OSRAM Opto Semiconductors GmbH, 93055 Regensburg (DE)
(72) Erfinder: Lindberg, Hans, 93138 Lappersdorf (DE); Illek, Stefan, 93093 Donaustauf (DE)
(74) Vertreter: Epping - Hermann - Fischer

(57) **Zusammenfassung**

Es ist eine Halbleiterlaservorrichtung (5) mit mindestens einem Halbleiterlaserchip (7) vorgesehen, wobei der Halbleiterlaserchip (7) eine aktive Schicht enthält, die elektromagnetische Strahlung emittiert. Zur Ausbildung eines Resonators (10) für die von der aktiven Schicht emittierte Strahlung ist mindestens ein Winkelreflektor (1) in dem Halbleiterlaserchip (7) ausgebildet. Der Winkelreflektor (1) weist eine erste und eine zweite reflektierende Oberfläche (14,15) auf, wobei die erste und die zweite reflektierende Oberfläche (14,15) zueinander in einem Winkel kleiner als 90 Grad angeordnet sind. Dadurch ergibt sich eine verbesserte Abstrahlcharakteristik der von der Halbleiterlaservorrichtung (5) emittierten Strahlung. Ein VCSEL (8) wird dabei von dem kantenemittierenenden Halbleiterlaser (7) optisch gepumpt, wobei das Pumpen durch den Resonator (10) effizienter gestaltet wird.

## Beschreibung

Diese Patentanmeldung beansprucht die Prioritäten der deutschen Patentanmeldung 10 2007 043 189.0 und der deutschen Patentanmeldung 10 2007 053 296.4, deren Offenbarungsgehalte hiermit durch Rückbezug aufgenommen werden.

Die Erfindung betrifft eine Halbleitervorrichtung mit einem Halbleiterlaserchip und einem Winkelreflektor gemäß Patentanspruch 1.

Laservorrichtungen mit einem Winkelreflektor sind beispielsweise aus der Druckschrift US 7,035,508 B2 bekannt. Diese Vorrichtungen weisen einen Wellenleiter auf, an dessen Ende ein Winkelreflektor angeordnet ist.

Winkelreflektoren bestehen aus mindestens zwei reflektierenden Flächen, die im Winkel von 90 Grad zueinander angeordnet sind. Auf eine der Flächen treffende Strahlung wird durch doppelte Reflexion an beiden Flächen in genau die Richtung zurückgeworfen, aus der die Strahlung kam. Das bedeutet, dass die Strahlung auf die erste reflektierende Fläche des Winkelreflektors auftrifft, von der ersten reflektierenden Fläche des Winkelreflektors auf die zweite reflektierende Fläche des Winkelreflektors reflektiert und von der zweiten reflektierenden Fläche so reflektiert wird, dass die ausfallenden Strahlen und die einfallenden Strahlen parallel zueinander verlaufen.

Ferner ist in der Druckschrift WO 2005/048423 A1 eine optisch gepumpte Halbleiterlaservorrichtung mit einem oberflächenemittierenden Vertikalemissionsbereich und einer monolithisch integrierten Pumpstrahlungsquelle zum optischen Pumpen des Vertikalemissionsbereichs beschrieben. Die Pumpstrahlungsquelle kann zwei gerade Resonatorendspiegel aufweisen, die rechtwinklig zueinander angeordnet sind.

Diese Vorrichtungen haben jedoch den Nachteil, dass infolge des rechten Winkels des Winkelreflektors im Abstrahlprofil der Laservorrichtung eine gestörte Verteilung der von der Vorrichtung emittierten Strahlung entsteht. Die gestörte Verteilung kommt dadurch zustande, dass Strahlung, die auf oder in die Nähe des Schnittpunkts der beiden Reflektorflächen des Winkelreflektors trifft, nicht dem wie oben beschriebenen Strahlengang der doppelten Reflexion folgt. Dadurch kann im Abstrahlprofil des Winkelreflektors ein unerwünschtes Intensitätsminimum entstehen, das zum Beispiel als dunkler Streifen sichtbar ist.

Ferner weisen Vorrichtungen, die in der Druckschrift US 7,035,508 B2 beschrieben sind, den Nachteil auf, dass diese Vorrichtungen lediglich für indexgeführte Strukturen anwendbar sind. Um eine Lasermode zu definieren, müssen diese Vorrichtungen einen Stegwellenleiter aufweisen.

Der Erfindung liegt die Aufgabe zugrunde, eine Halbleiterlaservorrichtung mit einer verbesserten Abstrahlcharakteristik der von der Vorrichtung emittierten Strahlung anzugeben.

Diese Aufgabe wird durch eine Halbleiterlaservorrichtung mit den Merkmalen des Anspruchs 1 gelöst. Vorteilhafte Ausführungsformen und bevorzugte Weiterbildungen der Vorrichtung sind Gegenstände der abhängigen Ansprüche.

Erfindungsgemäß ist eine Halbleiterlaservorrichtung mit mindestens einem Halbleiterlaserchip vorgesehen, wobei der Halbleiterlaserchip eine aktive Schicht enthält, die elektromagnetische Strahlung emittiert. Zur Ausbildung eines Resonators für die von der aktiven Schicht emittierte Strahlung ist mindestens ein Winkelreflektor in dem Halbleiterlaserchip ausgebildet. Der Winkelreflektor weist eine erste und eine zweite reflektierende Oberfläche auf, wobei die erste und die zweite reflektierende Oberfläche zueinander in einem Winkel kleiner als 90 Grad angeordnet sind.

Bevorzugt sind die erste und die zweite reflektierende Oberfläche zueinander in einem Winkel von mehr als 70 Grad und weniger als 90 Grad angeordnet.

Durch diese Anordnung der reflektierenden Oberflächen des Winkelreflektors wird eine verbesserte Abstrahlcharakteristik der von der Halbleiterlaservorrichtung emittierten Strahlung erreicht. Durch einen Winkel kleiner als 90 Grad der reflektierenden Oberflächen zueinander wird das Intensitätsminimum, das in einem rechten Winkel des Winkelreflektors auftreten kann, weitgehend vermieden, wodurch weitgehend dunkle Streifen im Abstrahlprofil der Halbleiterlaservorrichtung vermieden werden. Dadurch erhöhen sich die Effizienz und die Abstrahlqualität der Vorrichtung. Eine verbesserte Abstrahlcharakteristik wird mit Vorteil erreicht.

### Gemäß zumindest einer Ausführungsform der

Halbleiterlaservorrichtung ist der Winkelreflektor mittels Trockenätzung hergestellt. Eine Beschichtung der Oberflächen des Winkelreflektors ist mit Vorteil nur bedingt notwendig. Die Anforderungen an die Beschichtung der Oberflächen des Winkelreflektors reduzieren sich vorteilhaft. Beispielsweise kann anstelle einer reflexionserhöhenden Schichtenfolge eine Einfachschicht verwendet werden. Dadurch reduzieren sich vorteilhaft die Produktionskosten und die Produktionszeit einer solchen Halbleiterlaservorrichtung.

Gemäß zumindest einer weiteren Ausführungsform der Halbleiterlaservorrichtung treffen die von der aktiven Schicht emittierten Strahlen als einfallende Strahlen auf die erste reflektierende Oberfläche des Winkelreflektors auf, werden von der ersten reflektierenden Oberfläche auf die zweite reflektierende Oberfläche reflektiert und von der zweiten reflektierenden Oberfläche so reflektiert, dass die ausfallenden Strahlen und die einfallenden Strahlen nicht parallel zueinander verlaufen.

Bevorzugt definieren die einfallenden Strahlen und die ausfallenden Strahlen einen Strahlengang, wobei sich die einfallenden Strahlen und die ausfallenden Strahlen schneiden.

Die einfallenden und die ausfallenden Strahlen bilden bevorzugt einen in sich geschlossenen Strahlengang aus. Bevorzugt bilden alle Strahlen in dem Resonator einen in sich geschlossenen Strahlengang aus. Dadurch weist die von der Halbleiterlaservorrichtung emittierte Strahlung mit Vorteil eine maximale Eiffizienz auf.

Durch den nicht parallelen Strahlengang der einfallenden und ausfallenden Strahlen und durch den Schnittpunkt der einfallenden und ausfallenden Strahlen kann die Effizienz des Laserchips vorteilhaft erhöht werden. Des Weiteren ergibt sich mit Vorteil eine verbesserte Abstrahlcharakteristik des Laserchips, da das in einem rechten Winkel des Winkelreflektors auftretende Intensitätsminimum weitgehend vermieden wird.

Als Schnittpunkt wird im Folgenden kein Punkt im mathematisch korrekten Sinn bezeichnet. Vielmehr kann als Schnittpunkt im Folgenen ein 2-dimensionaler oder 3-dimensionaler Bereich bezeichnet werden, beispielsweise eine Schnittfläche oder ein Schnittvolumen, an dem sich die Strahlen der von der aktiven Schicht emittierten Strahlung schneiden.

Der Winkel zwischen den reflektierenden Oberflächen des Winkelreflektors kann bevorzugt so angeordnet sein, dass der Schnittpunkt der einfallenden und der ausfallenden Strahlen, an dem eine maximale Strahlungsintensität erzielt wird, an der Fläche angeordnet ist, an der die Strahlung aus dem Halbleiterlaserchip austritt. Dadurch kann eine maximale Abstrahlintensität der Strahlung des Halbleiterlaserchips erreicht werden.

Bevorzugt bilden die einfallenden Strahlen und die ausfallenden Strahlen einen Strahlengang aus, der den Schnittpunkt der ersten und der zweiten reflektierenden Oberfläche des Winkelreflektors nicht trifft. Durch den so bereitgestellten Strahlengang in dem Resonator lassen sich dunkle Streifen in dem Abstrahlprofil des Laserchips weitgehend vermeiden, da der rechte Winkel des Winkelreflektors und das damit verbundene, im rechten Winkel des Winkelreflektors auftretende Intensitätsminimum weitgehend vermieden wird. Eine verbesserte Lichtverteilung der von dem Laserchip emittierten Strahlung kann so erzielt werden.

Vorzugsweise weisen die erste reflektierende Oberfläche des Winkelreflektors und die einfallenden Strahlen einen Winkel größer als 20 Grad und kleiner als 45 Grad zueinander auf. Dadurch kann vorzugsweise weiter das Ausbleiben von dunklen Streifen im Abstrahlprofil des Laserchips erzielt werden.

Gemäß zumindest einer Ausführungsform der Halbleiterlaservorrichtung sind die erste und die zweite reflektierende Oberfläche des Winkelreflektors so zueinander angeordnet, dass die einfallenden Strahlen und die ausfallenden Strahlen an ihnen Totalreflexion erfahren. Dadurch lassen sich optische Verluste in dem Resonator weitgehend vermeiden.

Gemäß zumindest einer Ausführungsform ist der Halbleiterlaserchip als Kantenemitter ausgebildet. Bei einem Kantenemitter kann durch die Verringerung des Winkels zwischen den Oberflächen des Winkelreflektors eine maximale Intensität der von dem Kantenemitter emittierten Strahlung an der für die Emission der Strahlung vorgesehenen Kante des Chips erzielt werden. Ferner wird eine verbesserte Abstrahlcharakteristik der emittierten Strahlung des Kantenemitters erreicht. Dunkle Streifen im Abstrahlprofil der Strahlung werden weitgehend vermieden.

Gemäß zumindest einer weiteren Ausführungsform der Halbleiterlaservorrichtung bildet der Halbleiterlaserchip eine Pumpstrahlungsquelle aus, wobei auf Bereichen der Pumpstrahlungsquelle ein durch die von der aktiven Schicht emittierte Pumpstrahlung optisch gepumpter oberflächenemittierender Vertikalemitterlaser angeordnet ist.

Die Halbleiterlaservorrichtung ist bevorzugt so ausgebildet, dass der Vertikalemitterlaser auf Bereichen der Pumpstrahlungsquelle angeordnet ist, die elektrisch gepumpt werden. Bevorzugt werden die Bereiche der Pumpstrahlungsquelle elektrisch gepumpt, die den Resonator für die von der aktiven Schicht der Pumpstrahlungsquelle emittierte Strahlung ausbilden. Dadurch reduzieren sich mit Vorteil Verluste der von der aktiven Schicht der Pumpstrahlungsquelle emittierten Strahlung, die durch Absorption in nicht gepumpten Bereichen der aktiven Schicht der Pumpstrahlungsquelle enstehen können. Ferner werden lediglich die Bereiche der Pumpstrahlungsquelle elektrisch gepumpt, die den Resonator für die von der aktiven Schicht der Pumpstrahlungsquelle emittierte Strahlung ausbilden, die somit den Vertikalemitterlaser optisch pumpen und die folglich zur Lichterzeugung der Halbleiterlaservorrichtung beitragen. Insgesamt erhöht sich dadurch die Effizienz der von der Halbleiterlaservorrichtung emittierten Strahlung.

Durch einen Winkel zwischen den Oberflächen der Winkelreflektoren, der kleiner als 90 Grad ist, wird ein verbessertes optisches Pumpen des Vertikalemitterlasers durch die Pumpstrahlungsquelle erzielt. Ferner lassen sich optische Verluste in dem Resonator der Pumpstrahlungsquelle weitgehend vermeiden.

Gemäß zumindest einer weiteren Ausführungsform der Halbleiterlaservorrichtung ist in dem Halbleiterlaserchip auf einer dem Winkelreflektor gegenüberliegenden Seite ein weiterer Winkelreflektor ausgebildet, der zwei reflektierende Oberflächen aufweist, die zueinander in einem Winkel kleiner als 90 Grad angeordnet sind, wobei die Winkelreflektoren gemeinsam einen Resonator für die von der aktiven Schicht emittierte Strahlung ausbilden.

Bevorzugt weist der Strahlengang der Pumpstrahlung zwischen den Winkelreflektoren einen Schnittpunkt auf, der mit Vorteil unterhalb des Vertikalemitterlasers angeordnet ist. Eine hohe Intensität der Pumpstrahlung kann dadurch in Bereichen der Halbleiterlaservorrichtung erreicht werden, in denen bevorzugt optisches Pumpen auftreten soll.

Bevorzugt weist der Vertikalemitterlaser mindestens eine aktive strahlungserzeugende Vertikalemitterschicht auf, die in einer Vertikalhauptstrahlungsrichtung Strahlung emittiert und in der Vertikalhauptstrahlungsrichtung von der aktiven Schicht der Pumpstrahlungsquelle beabstandet ist.

Bevorzugt ist zwischen der Pumpstrahlungsquelle und dem Vertikalemitterlaser eine Zwischenschicht angeordnet, die die Pumpstrahlung der Pumpstrahlungsquelle aus dem Resonator der Pumpstrahlungsquelle auskoppelt und in den Vertikalemitterlaser einkoppelt.

Gemäß zumindest einer Ausführungsform der Halbleiterlaservorrichtung weist der Vertikalemitterlaser einen Resonatorspiegel auf, der senkrecht zur Vertikalhauptstrahlungsrichtung angeordnet ist. Der Resonatorspiegel ist bevorzugt zwischen der Vertikalemitterschicht und dem Substrat angeordnet. Dabei wird die von der Vertikalemitterschicht erzeugte Strahlung auf der dem Substrat gegenüberliegenden Seite des Vertikalemitterlasers ausgekoppelt ("top emitter"). Alternativ kann der Resonatorspiegel auf der dem Substrat gegenüberliegenden Seite der Vertikalemitterschicht angeordnet sein. Dabei wird die von der Vertikalemitterschicht erzeugte Strahlung durch das Substrat oder substratseitig, beispielsweise durch eine Öffnung in dem Substrat, ausgekoppelt ("bottom emitter").

Bevorzugt ist der Vertikalemitterschicht ein externer Spiegel zugeordnet, der zusammen mit dem Resonatorspiegel den Resonator für den Vertikalemitterlaser bildet.

Der Resonatorspiegel ist bevorzugt ein Bragg-Reflektor.

Bei einer weiteren Ausführungsform der Halbleiterlaservorrichtung sind mehrere Winkelreflektoren sternförmig um die Vertikalemitterschicht herum angeordnet.

Bevorzugt sind die Winkelreflektoren so zueinander angeordnet, dass jeweils auf einer einem Winkelreflektor gegenüberliegenden Seite ein weiterer Winkelreflektor ausgebildet ist.

Bevorzugt ist jeder Winkelreflektor so ausgebildet, dass die von der aktiven Schicht emittierten Strahlen jeweils als einfallende Strahlen auf die erste reflektierende Oberfläche eines Winkelreflektors treffen, von der ersten reflektierenden Oberfläche auf die zweite reflektierende Oberfläche reflektiert werden und von der zweiten reflektierenden Oberfläche so reflektiert werden, dass die einfallenden und die ausfallenden Strahlen nicht parallel zueinander verlaufen und sich schneiden.

Vorzugsweise sind die Winkelreflektoren so zueinander angeordnet, dass sich die Schnittpunkte der einfallenden und der ausfallenden Strahlen der einzelnen Winkelreflektoren überlagern, wobei die Schnittpunkte vorzugsweise unterhalb der Vertikalemitterschicht angeordnet sind.

In dem Bereich der Schnittpunkte kann eine hohe Pumpstrahlintensität erzielt werden. Auf diese Weise ergibt sich vorteilhafterweise eine verbesserte Abstrahlcharakteristik der Pumpstrahlungsquelle, wodurch ein homogenes optisches Pumpen durch die Pumpstrahlungsquelle ermöglicht wird. Der Bereich der Schnittpunkte der einfallenden und ausfallenden Strahlen der einzelnen Winkelreflektoren, der vorzugsweise unterhalb der Vertikalemitterschicht angeordnet ist, stellt eine hohe Intensität der Pumpstrahlung in Bereichen der Halbleiterlaservorrichtung bereit, in denen bevorzugt ein optisches Pumpen der Vertikalemitterschicht stattfinden soll.

Gemäß zumindest einer weiteren Ausführungsform der Halbleiterlaservorrichtung sind die Winkelreflektoren so zueinander angeordnet, dass die Winkelreflektoren einen Resonator ausbilden, in dem ein umlaufender Strahlengang ausgebildet ist.

Die aktive Schicht des Pumplasers weist bevorzugt einen pn-Übergang, eine Doppelheterostruktur, eine Einfachquantentopf- oder eine Mehrfachquantentopfstruktur (MWQ) zur Strahlungserzeugung auf. Die Bezeichnung Quantentopfstruktur umfasst im Rahmen der Anmeldung insbesondere jegliche Struktur, bei der Ladungsträger durch Einschluss ("confinements") eine Quantisierung ihrer Energiezustände erfahren können. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

Weitere Merkmale, Vorteile, bevorzugte Ausführungsformen und Zweckmäßigkeiten der Halbleiterlaservorrichtung ergeben sich aus den im Folgenden in Verbindung mit den Figuren erläuterten Ausführungsbeispielen.

Es zeigen:
Figur 1 einen schematischen Querschnitt eines ersten Ausführungsbeispiels einer erfindungsgemäßen Halbleiterlaservorrichtung,
Figur 2A eine schematische Draufsicht auf einen Resonator eines Halbleiterlaserchips einer erfindungsgemäßen Halbleiterlaservorrichtung, der als Pumpstrahlungsquelle ausgebildet ist,
Figur 2B eine schematische Draufsicht eines weiteren Resonators eines Halbleiterlaserchips einer erfindungsgemäßen Halbleiterlaservorrichtung, der als Kantenemitter ausgebildet ist,
Figur 3A eine schematische Draufsicht auf einen Resonator eines herkömmlichen Halbleiterlaserchips, der als Pumpstrahlungsquelle ausgebildet ist,
Figur 3B eine weitere schematische Draufsicht auf einen Resonator eines herkömmlichen Halbleiterlaserchips, der als Kantenemitter ausgebildet ist, und
Figur 4 jeweils eine schematische Draufsicht auf einen Resonator mit mehreren Winkelreflektoren eines Halbleiterlaserchips einer erfindungsgemäßen Halbleiterlaservorrichtung, der als Pumpstrahlungsquelle ausgebildet ist.

Gleiche oder gleichwirkende Bestandteile sind jeweils mit den gleichen Bezugszeichen versehen. Die dargestellten Bestandteile sowie die Größenverhältnisse der Bestandteile untereinander sind nicht notwendigerweise als maßstabsgetreu anzusehen.

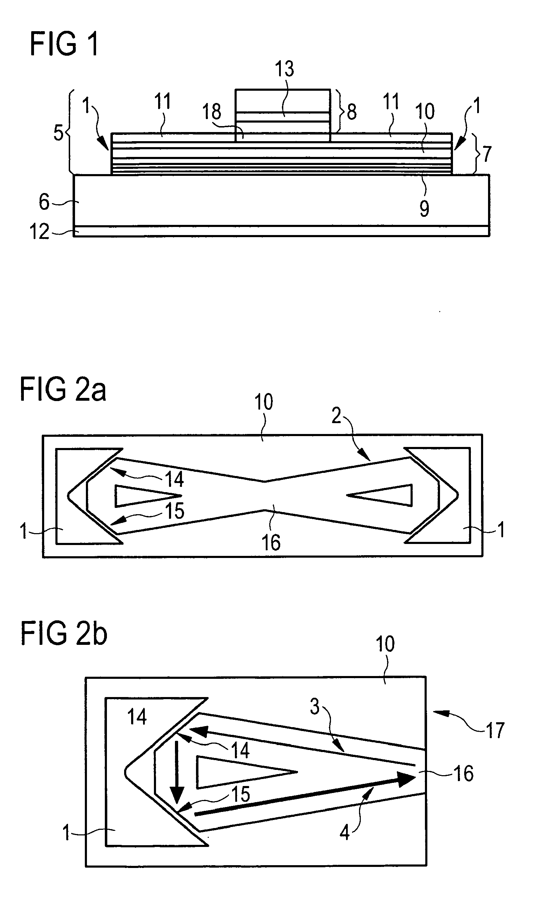

Bei der in Figur 1 dargestellten Halbleiterlaservorrichtung 5 ist ein oberflächenemittierender Vertikalemitterlaser 8 auf einem Halbleiterchip 7, der als Pumpstrahlungsquelle ausgebildet ist, angeordnet. Die Halbleiterlaservorrichtung 5 ist auf einem Substrat 6 angeordnet.

Das Substrat 6 weist auf einer der Pumpstrahlungsquelle 7 abgewandten Hauptfläche eine Kontaktfläche 12 zur elektrischen Kontaktierung der Pumpstrahlungsquelle 7 auf. Zur weiteren Kontaktierung der Pumpstrahlungsquelle 7 ist vorzugsweise eine elektrische Kontaktschicht 11 auf einer dem Substrat 6 abgewandten Seite aufgebracht. Die Kontaktschicht 11 weist in einem Bereich, auf dem der Vertikalemitterlaser 8 aufgebracht ist, eine Aussparung auf.

Der oberflächenemittierende Vertikalemitterlaser 8 weist eine aktive strahlungserzeugende Vertikalemitterschicht 13 auf. Die Pumpstrahlungsquelle 7 weist einen Resonator 10 auf, in dem eine aktive Schicht angeordnet ist, die elektromagnetische Strahlung in einer Hauptstrahlungsrichtung emittiert. Die aktive strahlungserzeugende

Vertikalemitterschicht 13 ist in der Vertikalhauptstrahlungsrichtung von dem Resonator 10 der Pumpstrahlungsquelle 7 beabstandet.

Zwischen der Pumpstrahlungsquelle 7 und dem Vertikalemitterlaser 8 ist eine Zwischenschicht 18 angeordnet. Die Zwischenschicht 18 koppelt die Pumpstrahlung der Pumpstrahlungsquelle 7 aus dem Resonator 10 der Pumpstrahlungsquelle 7 aus und in den Vertikalemitterlaser 8 ein.

Der Resonator 10 der Pumpstrahlungsquelle 7 weist an zwei sich gegenüber liegenden Enden des Resonators 10 jeweils einen Winkelreflektor 1 auf. Die Winkelreflektoren 1 weisen jeweils eine erste und eine zweite reflektierende Oberfläche auf, wobei die erste und die zweite reflektierende Oberfläche zueinander in einem Winkel kleiner als 90 Grad angeordnet sind. Bevorzugt sind die erste und die zweite reflektierende Oberfläche zueinander in einem Winkel von mehr als 70 Grad und weniger als 90 Grad angeordnet.

Die Pumpstrahlungsquelle 7 emittiert in einer Pumphauptstrahlungsrichtung Pumpstrahlung die quer zur Vertikalhauptstrahlungsrichtung verläuft. Die aktive Schicht 13 des Vertikalemitterlasers 8 wird durch die Pumpstrahlung der Pumpstrahlungsquelle 7 optisch gepumpt.

Durch einen Winkel zwischen den Oberflächen der Winkelreflektoren, der kleiner als 90 Grad ist, wird ein verbessertes optisches Pumpen des Vertikalemitterlasers 8 durch die Pumpstrahlungsquelle 7 erzielt.

Die Oberflächen der Winkelreflektoren 1 sind zueinander so angeordnet, dass Strahlung, die sich in dem Resonator 10 der Pumpstrahlungsquelle 7 befindet, an den Oberflächen der Winkelreflektoren 1 Totalreflektion erfährt. Mit Vorteil wird dadurch ein geringer optischer Verlust der Pumpstrahlung erreicht. Optische Verlust in dem Resonator 10 lassen sich somit weitgehend vorteilhaft vermeiden.

Bevorzugt sind die Winkelreflektoren durch Trockenätzung hergestellt. Eine Beschichtung der Oberflächen der Winkelreflektoren 1 ist mit Vorteil nur bedingt notwendig. Die Anforderungen an die Beschichtung der Oberflächen des Winkelreflektors 1 reduzieren sich vorteilhaft. Beispielsweise kann anstelle einer reflexionserhöhenden Schichtenfolge eine Einfachschicht verwendet werden. Dadurch reduzieren sich vorzugsweise die Produktionskosten und die Produktionszeit einer solchen Halbleiterlaservorrichtung 5.

Bevorzugt weist der Vertikalemitterlaser 8 einen Resonatorspiegel 9, beispielsweise einen Bragg-Reflektor, auf. Der Resonatorspiegel 9 ist bevorzugt senkrecht zur Vertikalhauptstrahlungsrichtung angeordnet. In der Figur 1 ist der Resonatorspiegel 9 zwischen der Pumpstrahlungsquelle 7 und dem Substrat 6 angeordnet. Dabei wird die von der Vertikalemitterschicht 13 erzeugte Strahlung auf einer dem Substrat 6 gegenüberliegenden Seite des Vertikalemitterlasers 8 ausgekoppelt ("top-emitter"). Alternativ kann der Resonatorspiegel 9 auf der dem Substrat 6 gegenüberliegenden Seite der Vertikalemitterschicht 13 angeordnet sein. Dabei wird die von der Vertikalemitterschicht 13 erzeugte Strahlung durch das Substrat 6 oder durch eine Öffnung in dem Substrat ausgekoppelt ("bottom-emitter").

Bevorzugt ist der Vertikalemitterschicht 13 ein externer Spiegel zugeordnet, der zusammen mit dem Resonatorspiegel 9 einen Resonator für den Vertikalemitterlaser 8 bildet (nicht dargestellt).

Bevorzugt weist die aktive Schicht der Pumpstrahlungsquelle 7 einen pn-Übergang, eine Doppelheterostruktur, eine Einfachquantentopf- oder eine Mehrfachquantentopfstruktur (MWQ) zur Strahlungserzeugung auf. Die Bezeichnung Quantentopfstruktur umfasst im Rahmen der Anmeldung insbesondere jegliche Struktur, bei der Ladungsträger durch Einschluss ("confinements") eine Quantisierung ihrer Energiezustände erfahren können. Insbesondere beinhaltet die Bezeichnung Quantentopfstruktur keine Angabe über die Dimensionalität der Quantisierung. Sie umfasst somit unter anderem Quantentröge, Quantendrähte und Quantenpunkte und jede Kombination dieser Strukturen.

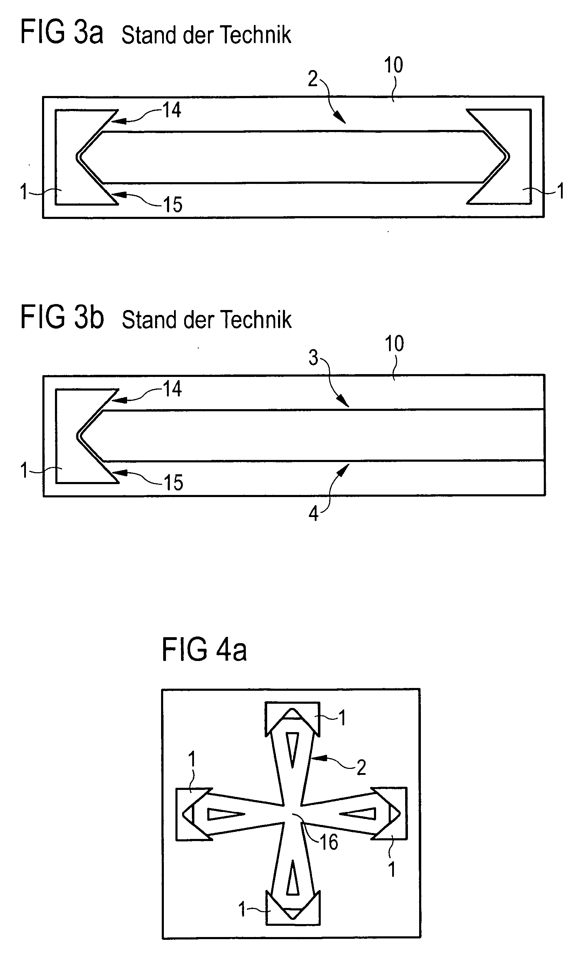

Bevorzugte Ausführungsbeispiele des Resonators 10 der Pumpstrahlungsquelle 7 und des Strahlengangs 2 der sich in dem Resonator 10 befindenden Strahlung sind in der Figur 2a und den Figuren 4a bis 4d dargestellt.

Figur 2a stellt ein Ausführungsbeispiel eines Resonators 10 der Pumpstrahlungsquelle der Halbleiterlaservorrichtung aus Figur 1 dar. An den beiden gegenüberliegenden Enden des Resonators 10 ist jeweils ein Winkelreflektor 1 angeordnet. Die erste Oberfläche 14 und die zweite Oberfläche 15 der Winkelreflektoren 1 sind zueinander in einem Winkel kleiner als 90 Grad angeordnet.

Durch diese Anordnung der reflektierenden Oberflächen 14, 15 des Winkelreflektors 1 wird eine verbesserte Abstrahlcharakteristik der von der Halbleiterlaservorrichtung emittierten Strahlung erreicht. Durch einen Winkel kleiner als 90 Grad der reflektierenden Oberflächen 14, 15 zueinander werden dunkle Streifen im Abstrahlprofil der Halbleiterlaservorrichtung weitgehend vermieden, da das in einem rechten Winkel auftretende Intensitätsminimum weitgehend vermieden wird. Dadurch erhöhen sich die Effizienz und die Abstrahlqualität der Vorrichtung. Eine verbesserte Abstrahlcharakteristik wird mit Vorteil erreicht.

Zwischen den zwei Winkelreflektoren 1 bildet sich ein Strahlengang 2 in dem Resonator 10 aus. Der Strahlengang 2 weist bevorzugt einen Schnittpunkt 16 der Strahlung auf. Der Schnittpunkt 16 des Strahlengangs 2 ergibt sich durch den Winkel zwischen den Oberflächen 14, 15 der Winkelreflektoren 1.

Mit Vorteil wird an dem Schnittpunkt 16 des Strahlengangs 2 eine maximale Strahlungsintensität der Pumpstrahlungsquelle erzielt. Ferner ergibt sich am Schnittpunkt 16 vorzugsweise ein verbessertes optisches Pumpen des Vertikalemitterlasers durch die Pumpstrahlung der Pumpstrahlungsquelle.

Die Winkelreflektoren 1 sind bevorzugt so zueinander angeordnet, dass sich die von der aktiven Schicht emittierte Strahlung schneidet, wobei der Schnittpunkt unterhalb der Vertikalemitterschicht angeordnet ist. Eine hohe Intensität der Pumpstrahlung kann dadurch in Bereichen der Halbleiterlaservorrichtung erreicht werden, in denen bevorzugt optisches Pumpen auftreten soll.

Bevorzugt trifft der Strahlengang 2 den Schnittpunkt der ersten und der zweiten reflektierenden Oberfläche 14, 15 des Winkelreflektors 1 nicht. Durch den so bereitgestellten Strahlengang 2 in dem Resonator 10 lassen sich dunkle Streifen in dem Abstrahlprofil der Pumpstrahlungsquelle weitgehend vermeiden, da das in einem rechten Winkel auftretende Intensitätsminimum vermieden wird. Eine verbesserte Lichtverteilung der von der Pumpstrahlungsquelle emittierten Strahlung kann so erzielt werden.

Figur 2b gibt ein Ausführungsbeispiel eines Resonators 10 eines Halbleiterlaserchips wieder, der als Kantenemitter ausgebildet ist. An einem Ende des Resonators 10 ist ein Winkelreflektor 1 angeordnet, der zwei Oberflächen 14, 15 aufweist, die in einem Winkel zueinander von kleiner als 90 Grad angeordnet sind.

Die einfallenden Strahlen 3, die auf die erste reflektierende Oberfläche 14 fallen, werden von der ersten reflektierenden Oberfläche 14 auf die zweite reflektierenden Oberfläche 15 reflektiert, und von der zweiten reflektierenden Oberfläche 15 als ausfallende Strahlen 4 so reflektiert, dass die ausfallenden Strahlen 4 und die einfallenden Strahlen 3 nicht parallel zueinander verlaufen.

Bevorzugt schneiden sich die einfallenden Strahlen 3 und die ausfallenden Strahlen 4. Durch den nicht parallelen Strahlengang der einfallenden und ausfallenden Strahlen 3, 4 und durch den Schnittpunkt 16 der einfallenden und ausfallenden Strahlen 3, 4 kann die Effizienz des Kantenemitters am Schnittpunkt 16 vorteilhaft erhöht werden. Ferner ergibt sich mit Vorteil eine verbesserte Abstrahlcharakteristik des Kantenemitters.

Der Winkel zwischen den reflektierenden Oberflächen 14, 15 des Winkelreflektors 1 kann bevorzugt so angeordnet sein, dass der Schnittpunkt 16 der einfallenden und der ausfallenden Strahlen 3, 4, an dem eine maximale Strahlungsintensität erzielt wird, an der für die Emission der Strahlung vorgesehenen Kante 17 des Chips angeordnet ist. Dadurch kann eine maximale Abstrahlintensität der von dem Kantenemitter emittierten Strahlung an der für die Emission der Strahlung vorgesehenen Kante 17 des Chips erzielt werden. Ferner wird eine verbesserte Abstrahlcharakteristik der emittierten Strahlung des Kantenemitters erreicht. Dunkle Streifen in dem Abstrahlprofil der Strahlung werden weitgehend vermieden.

Bevorzugt bilden die einfallenden Strahlen 3 und die ausfallenden Strahlen 4 einen Strahlengang aus, der den Schnittpunkt der ersten und der zweiten reflektierenden Oberfläche 14, 15 des Winkelreflektors 1 nicht trifft. Durch den so bereitgestellten Strahlengang in dem Resonator 10 lassen sich dunkle Streifen in dem Abstrahlprofil des Kantenemitters weitgehend vermeiden, da das in einem rechten Winkel auftretende Intensitätsminimum weitgehend vermieden wird. Eine verbesserte Lichtverteilung der von dem Kantenemitter emittierten Strahlung kann so erzielt werden.

Vorzugsweise weisen die erste reflektierende Oberfläche 14 des Winkelreflektors 1 und die einfallenden Strahlen 3 einen Winkel kleiner als 45 Grad zueinander auf. Dadurch lässt sich vorzugsweise weiter ein Ausbleiben von dunklen Streifen im Abstrahlprofil des Kantenemitters erzielen.

In den Figuren 3a und 3b sind Ausführungsbeispiele herkömmlicher Resonatoren 10 dargestellt. Figur 3a zeigt einen herkömmlichen Resonator 10, der in einer Pumpstrahlungsquelle angeordnet ist. Ein Resonator 10 einer als herkömmlicher Kantenemitter ausgelegten Struktur ist in Figur 3b gezeigt.

Die Winkelreflektoren 1, die in den Figuren 3a und 3b dargestellt sind, weisen zwei Oberflächen 14, 15 auf, die in einem Winkel von 90 Grad zueinander angeordnet sind. Durch den Winkel von 90 Grad ergibt sich ein paralleler Strahlengang 2 für die sich in dem Resonator 10 ausbreitende, von der aktiven Schicht emittierte Strahlung 2.

Der Resonator 10 weist einfallende Strahlen 3 und ausfallende Strahlen 4 auf, die sich aus der in dem Resonator 10 ausbreitenden emittierten Strahlung der aktiven Schicht ergeben. Auf eine Oberfläche 14 treffende Strahlung wird durch doppelte Reflexion an beiden Oberflächen 14, 15 in genau die Richtung zurückgeworfen, aus der die Strahlung kam. Das bedeutet, dass Strahlen als einfallende Strahlen 3 auf die erste reflektierende Oberfläche 14 des Winkelreflektors 1 auftreffen, von der ersten reflektierenden Oberfläche 14 des Winkelreflektors 1 auf die zweite reflektierende Oberfläche 15 des Winkelreflektors 1 reflektiert und von der zweiten reflektierenden Oberfläche 15 so reflektiert werden, dass die ausfallenden Strahlen 4 und die einfallenden Strahlen 3 parallel zueinander verlaufen.

Der Strahlengang 2 trifft den Schnittpunkt der ersten und der zweiten reflektierenden Oberfläche 14, 15 des Winkelreflektors 1. Strahlung, die auf oder in die Nähe des rechten Winkel des Winkelreflektors trifft, folgt jedoch nicht den wie oben beschriebenen Strahlengang der doppelten Reflexion. Dadurch kann im Abstrahlprofil des Halbleiterlaserchips im rechten Winkel des Winkelreflektors ein unerwünschtes Intensitätsminimum entstehen, das zum Beispiel als dunkler Streifen sichtbar ist. Nachteilig ergibt sich eine inhomogene Abstrahlcharakteristik der von dem Halbleiterlaserchip emittierten Strahlung.

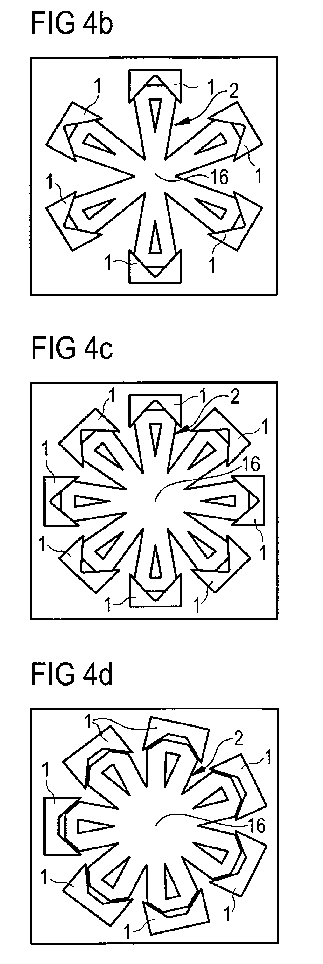

Die in Figur 4 dargestellten Ausführungsbeispiele von einem Resonator, der in einem Halbleiterlaserchip angeordnet ist, unterscheiden sich von dem Beispiel aus Figur 2a dadurch, dass mehrere Winkelreflektoren 1 angeordnet sind. Die Winkelreflektoren 1 bilden jeweils einen umlaufenden Strahlengang 2 aus.

Die Winkelreflektoren 1 sind jeweils sternförmig um die Vertikalemitterschicht herum angeordnet. In den Figuren 4a bis 4d sind die Winkelreflektoren 1 jeweils so ausgebildet, dass die von der aktiven Schicht emittierte Strahlung jeweils auf die erste reflektierende Oberfläche eines Winkelreflektors 1 trifft, von der ersten reflektierenden Oberfläche auf die zweite reflektierende Oberfläche reflektiert wird und von der zweiten reflektierenden Oberfläche so reflektiert wird, dass die einfallenden und die ausfallenden Strahlen nicht parallel zueinander verlaufen und sich schneiden.

Die Winkelreflektoren 1 sind in den Figuren 4a bis 4d so zueinander angeordnet, dass sich die Schnittpunkte der einfallenden und der ausfallenden Strahlen der einzelnen Winkelreflektoren 1 unterhalb der Vertikalemitterschicht überlagern.

In dem Bereich der Schnittpunkte 16 kann eine hohe Pumpstrahlintensität erzielt werden. Auf diese Weise ergibt sich vorteilhafterweise eine verbesserte Abstrahlcharakteristik der Pumpstrahlungsquelle, wodurch ein homogenes optisches Pumpen durch die Pumpstrahlungsquelle ermöglicht wird. Der Bereich der Schnittspunkte 16 der einfallenden und ausfallenden Strahlen der einzelnen Winkelreflektoren 1, der vorzugsweise unterhalb der Vertikalemitterschicht angeordnet ist, stellt eine hohe Intensität der Pumpstrahlung in Bereichen der Halbleiterlaservorrichtung bereit, in denen bevorzugt ein optisches Pumpen der Vertikalemitterschicht stattfinden soll.

Die Winkelreflektoren 1 sind in den Figuren 4a bis 4d so zueinander angeordnet, dass die Winkelreflektoren 1 einen Resonator ausbilden, in dem ein umlaufender Strahlengang 2 ausgebildet ist, wobei sich geschlossene Strahlengänge 2 der von der aktiven Schicht emittierten Strahlung bilden.

Die Erfindung ist nicht durch die Beschreibung anhand der Ausführungsbeispiele auf diese beschränkt. Vielmehr umfasst die Erfindung jedes neue Merkmal sowie jede Kombination von Merkmalen, was insbesondere jede Kombination von Merkmalen in den Patentansprüchen beinhaltet, auch wenn dieses Merkmal oder diese Kombination selbst nicht explizit in den Patentansprüchen oder Ausführungsbeispielen angegeben ist.

## Patentansprüche

1. Halbleiterlaservorrichtung mit mindestens einem Halbleiterlaserchip (7), wobei
- der Halbleiterlaserchip (7) eine aktive Schicht enthält, die elektromagnetische Strahlung emittiert, und
- zur Ausbildung eines Resonators (10) für die von der aktiven Schicht emittierte Strahlung mindestens ein Winkelreflektor (1) in dem Halbleiterlaserchip (7) ausgebildet ist, der eine erste und eine zweite reflektierende Oberfläche (14, 15) aufweist, wobei die erste und die zweite reflektierende Oberfläche (14, 15) zueinander in einem Winkel kleiner als 90 Grad angeordnet sind.

2. Halbleiterlaservorrichtung gemäß Anspruch 1,
wobei die von der aktiven Schicht emittierten Strahlen als einfallende Strahlen (3) auf die erste reflektierende Oberfläche (14) des Winkelreflektors (1) auftreffen, von der ersten reflektierenden Oberfläche (14) auf die zweite reflektierende Oberfläche (15) reflektiert werden und von der zweiten reflektierenden Oberfläche (15) als ausfallende Strahlen (4) so reflektiert werden, dass die ausfallenden Strahlen (4) und die einfallenden Strahlen (3) nicht parallel zueinander verlaufen.

3. Halbleiterlaservorrichtung gemäß Anspruch 2,
wobei die einfallenden Strahlen (3) und die ausfallenden Strahlen (4) einen Strahlengang (2) definieren, und sich die einfallenden Strahlen (3) und die ausfallenden Strahlen (4) schneiden.

4. Halbleiterlaservorrichtung gemäß einem der Ansprüche 2 oder 3,
wobei die einfallenden Strahlen (3) und die ausfallenden Strahlen (4) einen Strahlengang (2) definieren, der den Schnittpunkt der ersten und der zweiten reflektierenden Oberfläche (14, 15) des Winkelreflektors (1) nicht trifft.

5. Halbleiterlaservorrichtung gemäß einem der Ansprüche 2 bis 4,
wobei die erste reflektierende Oberfläche (14) des Winkelreflektors (1) und die einfallenden Strahlen (3) einen Winkel größer als 20 Grad und kleiner als 45 Grad zueinander aufweisen.

6. Halbleiterlaservorrichtung gemäß einem der vorhergehenden Ansprüche,
wobei der Halbleiterlaserchip als Kantenemitter ausgebildet ist.

7. Halbleiterlaservorrichtung gemäß einem der Ansprüche 1 bis 5,
wobei in dem Halbleiterlaserchip (7) auf einer dem Winkelreflektor (1) gegenüberliegenden Seite ein weiterer Winkelreflektor (1) ausgebildet ist, der zwei reflektierende Oberflächen (14, 15) aufweist, die zueinander in einem Winkel kleiner als 90 Grad angeordnet sind und die Winkelreflektoren (1) gemeinsam einen Resonator (10) für die von der aktiven Schicht emittierte Strahlung ausbilden.

8. Halbleiterlaservorrichtung gemäß Anspruch 7, wobei der Halbleiterlaserchip (7) eine Pumpstrahlungsquelle ausbildet und auf der Pumpstrahlungsquelle (7) ein durch die von der aktiven Schicht emittierte Pumpstrahlung optisch gepumpter oberflächenemittierender Vertikalemitterlaser (8) angeordnet ist.

9. Halbleiterlaservorrichtung gemäß Anspruch 8,
wobei der Vertikalemitterlaser (8) mindestens eine aktive strahlungserzeugende Vertikalemitterschicht (13) aufweist, die in einer Vertikalhauptstrahlungsrichtung Strahlung emittiert und in der Vertikalhauptstrahlungsrichtung von der aktiven Schicht der Pumpstrahlungsquelle beabstandet ist.

10. Halbleiterlaservorrichtung gemäß Anspruch 9,
wobei der Halbleiterlaserchip (7) auf einem Substrat (6) angeordnet ist, ein Resonatorspiegel (9) zwischen der Vertikalemitterschicht (13) und dem Substrat (6) angeordnet ist und die von der Vertikalemitterschicht (13) erzeugte Strahlung auf der dem Substrat (6) gegenüberliegenden Seite des Vertikalemitterlasers (8) ausgekoppelt wird.

11. Halbleiterlaservorrichtung gemäß Anspruch 9,
wobei der Halbleiterlaserchip (7) auf einem Substrat (6) angeordnet ist, der Resonatorspiegel (9) auf der dem Substrat (6) gegenüberliegenden Seite der Vertikalemitterschicht (13) angeordnet ist und die von der Vertikalemitterschicht (13) erzeugte Strahlung durch das Substrat (6) oder substratseitig ausgekoppelt wird.

12. Halbleiterlaservorrichtung gemäß einem der Ansprüche 9 bis 11,
wobei der Vertikalemitterschicht (13) ein externer Spiegel zugeordnet ist, der zusammen mit dem Resonatorspiegel (9) einen Resonator für den Vertikalemitterlaser (8) bildet.

13. Halbleiterlaservorrichtung gemäß einem der Ansprüche 8 bis 12,
wobei mehrere Winkelreflektoren (1) sternförmig um die Vertikalemitterschicht (13) herum angeordnet sind.

14. Halbleiterlaservorrichtung gemäß Anspruch 13,
wobei die Winkelreflektoren (1) so zueinander angeordnet sind, dass sich die von der aktiven Schicht emittierte Strahlung unterhalb der Vertikalemitterschicht (13) schneidet.

15. Halbleiterlaservorrichtung gemäß einem der Ansprüche 13 oder 14,
wobei die Winkelreflektoren (1) so zueinander angeordnet sind, dass die Winkelreflektoren (1) einen Resonator ausbilden, in dem ein umlaufender Strahlengang ausgebildet ist.
